# EUROPÄISCHE PATENTSCHRIFT

(11) **EP 1 961 282 B1**
(45) Veröffentlichungstag und Bekanntmachung des Hinweises auf die Patenterteilung: **17.02.2010**
(21) Anmeldenummer: 06817485.3
(22) Anmeldetag: 11.12.2006
(51) Int. Cl.: H05K 9/00, H05K 1/05, H01L 23/36, H01L 23/373

(54) **ANORDNUNG MIT ZUMINDEST EINEM ELEKTRONISCHEN BAUTEIL**
ARRANGEMENT COMPRISING AT LEAST ONE ELECTRONIC COMPONENT
ENSEMBLE COMPORTANT AU MOINS UN COMPOSANT ELECTRONIQUE

(30) Priorität: 13.12.2005 AT 19832005
(43) Veröffentlichungstag der Anmeldung: 27.08.2008
(73) Patentinhaber: B2 Electronic GmbH, 6833 Klaus (AT)
(72) Erfinder: BALDAUF, Stefan, A-6830 Rankweil (AT); BLANK, Rudolf, A-6832 Sulz (AT)
(74) Vertreter: Torggler, Paul Norbert
(86) Internationale Anmeldenummer: PCT/AT2006/000510
(87) Internationale Veröffentlichungsnummer: WO 2007/068018

(56) Entgegenhaltungen:
- EP-A1- 0 785 708
- JP-A- 2003 109 972
- JP-A- 2004 087 735

## Beschreibung

Die vorliegende Erfindung betrifft eine Anordnung mit zumindest einem elektronischen Bauteil und einem diesem zugeordneten Kühlkörper sowie einem räumlich zwischen dem elektronischen Bauteil und dem Kühlkörper angeordneten Trägerkörper, welcher zumindest eine Schicht mit zumindest einem Material mit einer Durchschlagfestigkeit von mindestens 10 kV/mm und einer spezifischen Wärmeleitfähigkeit von mindestens 5 W/mK aufweist.

Darüber hinaus betrifft die Erfindung auch eine Schicht, einen Trägerkörper und/oder eine Einheit aus Trägerkörper und Kühlkörper, welche für eine solche Anordnung geeignet sind.

Bei zahlreichen elektronischen Bauteilen besteht das Problem, dass einerseits beim Betrieb des elektronischen Bauteils entstehende Wärme abgeführt werden muss, andererseits aber auch die nötige Durchschlagsfestigkeit, also elektrische Isolierung zur Verhinderung von ungewollten elektrischen Entladungen bzw. Kurzschlüssen sichergestellt werden muss. Bei den meisten Materialien mit hohen elektrischen Widerständen, also guter Durchschlagsfestigkeit sind die spezifischen Wärmeleitfähigkeiten so gering, sodass die Wärme nur unzureichend vom elektrischen Bauteil abtransportiert werden kann. Beim Stand der Technik ist es bereits bekannt, Trägerkörper zwischen dem elektronischen Bauteil und einem zugeordneten Kühlkörper zu verwenden, die gleichzeitig eine hohe Durchschlagsfestigkeit von mindestens 10 kV/mm und eine relativ hohe spezifische Wärmeleitfähigkeit von mindestens 5 W/mK aufweisen. Durch diese Maßnahme wird zwar die Wärme gut durch den Trägerkörper hindurch zum Kühlkörper transportiert und gleichzeitig eine ausreichende Durchschlagsfestigkeit gewährleistet, es stellt sich aber immer noch das Problem, dass es durch Kriechströme außerhalb des Trägerkörpers zu ungewollten elektrischen Entladungen bzw. Kurzschlüssen kommen kann. Dies gilt vor allem für den so genannten Hochspannungsbereich mit elektrischen Betriebsspannungen im kV(Kilovolt)-Bereich.

Aufgabe der Erfindung ist es, dieses Problem der beim Stand Technik bekannten gattungsgemäßen Anordnungen zu beseitigen.

Dies wird erreicht, indem in und/oder an der genannten Schicht des Trägerkörpers zumindest eine Ausnehmung und/oder zumindest ein vorstehendes Element angeordnet ist, die und/oder das so ausgebildet ist, dass sie und/oder es entlang der Oberfläche der Schicht des Trägerkörpers, vorzugsweise alle, elektrisch möglichen Wegsamkeiten zwischen dem elektronischen Bauteil und dem Kühlkörper gegenüber dem Zustand der Schicht des Trägerkörpers ohne die Ausnehmung und/oder ohne das vorstehende Element verlängert(n).

Es ist also vorgesehen, die Oberflächen der Schicht des Trägerkörpers mittels zumindest einer Ausnehmung und/oder zumindest eines vorstehenden Elementes zumindest so zu vergrößern, dass die Kriechwege in der Weise verlängert werden, dass es außerhalb des Trägerkörpers bzw. der Schicht entlang der Oberflächen nicht mehr zu Spannungsentladungen oder Kurzschlüssen kommen kann. Dabei ist es günstig, wenn alle elektrisch möglichen Wegsamkeiten verlängert werden. Dies wird bevorzugt dadurch erreicht, dass die Ausnehmung und/oder das vorstehende Element umlaufend bezüglich der Schicht des Trägerkörpers und/oder des elektronischen Bauteils und/oder des Kühlkörpers ausgebildet ist.

Grundsätzlich ist es nicht so sehr entscheidend, ob die Kriechwegverlängerung durch mikroskopische Ausnehmungen und/oder vorstehende Elemente, wie Aufrauung oder dergleichen, oder durch eher makroskopische Ausnehmungen oder vorstehende Elemente erreicht wird. Fertigungstechnisch ist es dabei aber besonders einfach, wenn die Ausnehmung nut- oder grabenförmig und/oder das vorstehende Elemente wandförmig ausgebildet ist. Letztendlich kommt es aber unabhängig von der Art der Realisierung hauptsächlich auf eine entsprechend große Verlängerung der Kriechwege an. In der Regel ist es dabei günstig, wenn die Ausnehmung und/oder das vorstehende Element so ausgebildet ist (sind), dass sie und/oder es die elektrisch möglichen Wegsamkeiten zwischen dem elektronischen Bauteil und dem Kühlkörper um mindestens 30 %, vorzugsweise mindestens 100 %, verlängert.

Fertigungstechnisch einfach ist es wiederum, wenn die gesamte Schicht, vorzugsweise der gesamte Trägerkörper, und/oder das mindestens eine gegebenenfalls vorhandene vorstehende Element aus ein und demselben Material gefertigt ist (sind). Dabei kann eine einstückige Ausbildung der gesamten Schicht bzw. des gesamten Trägerkörpers und der (des) gegebenenfalls vorstehenden Elemente(s) vorgesehen sein. Es ist aber auch möglich die gesamte Schicht bzw. den Trägerkörper und die gegebenenfalls vorstehenden Elemente, vorzugsweise durch Verkleben, aus miteinander verbundenen Einzelteilen aufzubauen.

Besonders günstige Materialien für die Schicht bzw. den Trägerkörper und die (das) gegebenenfalls vorhandenen vorstehende(n) Element(e) weisen neben der Durchschlagsfestigkeit von mindestens 10 kV/mm (Kilovolt pro Millimeter) eine spezifische Wärmeleitfähigkeit von mindestens 10 W/mK (Watt pro Meter Kelvin) auf. Besonders bevorzugte Materialien sind Keramiken wie Aluminiumoxid (ALO) mit einer Durchschlagsfestigkeit von ca. 10 kV/mm und einer spezifischen Wärmeleitfähigkeit von ca. 25 W/mK oder Aluminiumnitrid (ALN) mit Durchschlagsfestigkeiten von ca. 25 kV/mm und spezifischen Wärmeleitfähigkeiten von ca. 150 W/mK.

Besonders bevorzugt kommen die erfindungsgemäßen Anordnungen dann zum Einsatz, wenn es sich bei den elektronischen Bauteilen um Hochspannungsbauteile, welche für Betriebsspannungen von mindestens 5 kV bzw. zwischen 5 kV und 400 kV vorgesehen sind. Die als Wärme abzuführenden Verlustleistungen solcher Bauteile liegen meist bei mindestens 10 W (Watt) bzw. zwischen 10 W und 10 kW (Kilowatt).

Um nicht nur Kurzschlüsse bzw. Entladungen entlang der Kriechwege an den Oberflächen der Schicht bzw. des Trägerkörpers sondern auch entlang anderer Wegsamkeiten außerhalb der Schicht- bzw. des Trägerkörpers zu verhindern, kann zusätzlich vorgesehen sein, dass das elektronische Bauteil und/oder die Schicht, vorzugsweise der Trägerkörper, mit der (den) Ausnehmung(en) und/oder dem (den) vorstehenden Element(en) in ein elektrisch isolierendes Medium, vorzugsweise in ein Isolieröl oder ein Isoliergas oder ein Gießharz, vorzugsweise vollständig, eingebettet ist (sind).

Weitere Merkmale und Einzelheiten der vorliegenden Erfindung ergeben sich aus der nachfolgenden Figurenbeschreibung. Dabei zeigen:
- Fig. 1 und 2: ein erstes erfindungsgemäßes Ausführungsbeispiel mit einer nutförmigen umlaufenden Ausnehmung in geschnittener und perspektivischer Darstellung,
- Fig. 3: ein weiteres erfindungsgemäßes Ausführungsbeispiel, bei dem der Trägerkörper einstückig aufgebaut ist.
- Fig. 4 und 5: weitere Varianten von erfindungsgemäßen Ausführungsformen mit nutförmigen Ausnehmungen in Schnittdarstellungen und
- Fig. 6 bis 8: ein erfindungsgemäßes Ausführungsbeispiel mit einer grabenförmigen Ausnehmung.

Die Ausführungsbeispiele der Erfindung zeigen kombinierte Kühl- und Isolationssysteme, insbesondere für Hochspannungsapplikationen, bei denen als elektronische Bauteile 1 zum Beispiel Hochspannungsverstärker, steuerbare Hochspannungs- und Hochleistungswiderstände, Transistoren, Triacs, Dioden oder ähnliche Applikationen, welche zum einen gut gekühlt und zum anderen gegen, insbesondere sehr hohe, Spannungen isoliert werden müssen. Gezeigt sind mögliche Aufbauten, bei denen die Trägerkörper aus zumindest einer Schicht 2, bestehend aus Aluminiumnitrid oder Aluminiumoxid, aufgebaut sind. Verwendbar sind auch andere Materialien mit entsprechend guter spezifischer Wärmeleitfähigkeit und hoher Spannungsfestigkeit. Bei den verschiedenen gezeigten Ausführungsbeispielen ist der Trägerkörper bzw. die ihn bildende Schicht 2 von der Grundstruktur her, also ohne die gezeigten Ausnehmungen 5 im Wesentlichen quaderförmig in Form einer Platte ausgeführt. Der Trägerkörper bzw. die ihn bildende Schicht 2 hat für den Hochspannungsbereich günstigerweise eine Mindestkantenlänge 6 von 100 mm und/oder eine Mindestdicke 7 von 2 mm. Bei den gezeigten Ausführungsbeispielen sind zur Verlängerung der Kriechwege an der Oberfläche der Schicht 2 bzw. des Trägerkörpers rundum verlaufende nutförmige Ausnehmungen 5 vorgesehen. Die Tiefe und die Breite der Ausnehmung(en) 5 bzw. der Nut(en) ist abhängig von der geforderten Spannungsfestigkeit und der entsprechend anvisierten Verlängerung des Kriechweges. Das zu kühlende elektronische Bauelement 1 kann auf den Trägerkörper bzw. die Schicht 2 zum Beispiel aufgeklebt oder aufgespannt werden. Das Gleiche gilt für den Kühlkörper 3 auf der gegenüber liegenden Seite. Der Kühlkörper 3 weist in allen Ausführungsbeispielen Kühlrippen auf. Er kann dasselbe Material wie die Schicht 2 aber auch Aluminium oder andere gut wärmeableitende Materialien aufweisen.

Alle gezeigten Anordnungen werden mit einem isolierenden Medium 4, wie zum Beispiel Isolieröl oder Isoliergas oder Gießharz, ausgegossen bzw. umgeben. Dabei werden die Ausnehmungen 5 mit dem isolierenden Material 4 gefüllt. Die Temperaturübertragung vom elektronischen Bauteil 1 zum Kühlkörper erfolgt über den Trägerkörper bzw. die Schicht 2. Dieser bzw. diese sorgt auch für die entsprechende Spannungsfestigkeit auf dem direkten Weg zwischen elektronischen Bauelement 1 und Kühlkörper 3. Zur Verhinderung von Kriechströmen dient die erfindungsgemäße Wegverlängerung mittels der Ausnehmung(en) 5 bzw. der (des) hier nicht explizit gezeigten aber auch möglichen vorstehenden Elemente(s). Mittels des isolierenden Materials 4 wird darüber hinaus verhindert, dass es zu elektrischen Entladungen zwischen dem elektronischen Bauteil 1 und dem Kühlkörper 3 durch das die Anordnung umgebende Medium, wie zum Beispiel Luft, kommen kann. Bevorzugt wird der Kriechweg durch die erfindungsgemäßen Maßnahmen mindestens verdoppelt oder verdreifacht. Vor allem bei der Verwendung von Ausnehmungen 5 ist eine besonders kompakte und leichte Bauform möglich.

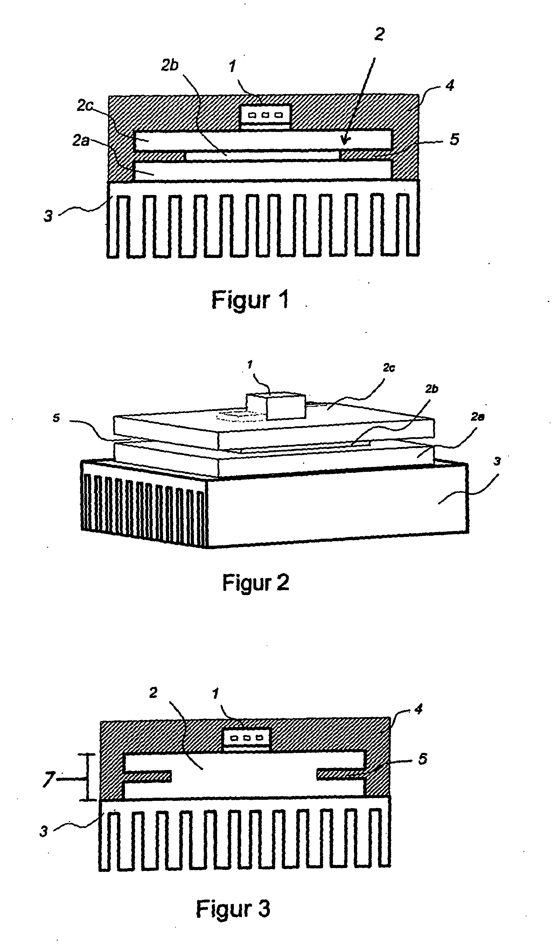

Zur Anordnung der Leiterbahnen zum elektrischen Kontaktieren der elektronischen Bauteile kann vorgesehen sein, dass die Leiterbahnen auf oder in dem Trägerkörper, zum Beispiel durch Aufdampfen, angeordnet werden. Günstiger Weise ist jedoch vorgesehen, dass die elektrische Kontaktierung und/oder die elektrischen Zu- oder Ableitungen zum elektronischen Bauteil außerhalb der Schicht 2 und/oder des Trägerkörpers angeordnet sind. In diesem Fall handelt es sich bei der Schicht 2 bzw. dem Trägerkörper also nicht um einen Träger für Leiterbahnen oder dergleichen. Die elektrischen Anschlüsse können anderweitig - hier nicht dargestellt - zum Beispiel durch direkt zum elektronischen Bauteil 1 führende Kabel oder oberhalb des Bauteils 1, also gegenüber dem Träger angeordnete, hier ebenfalls nicht dargestellte Leiterbahnen oder Platinen erfolgen. In dem Ausführungsbeispiel gemäß Fig. 1 und 2 ist eine nutförmige Ausnehmung 5 in der Schicht 2 vollständig umlaufend vorhanden. Es werden dadurch alle elektrisch möglichen Wegsamkeiten zwischen dem elektronischen Bauteil 1 und dem Kühlkörper 3 entlang der Kriechwege verlängert. Fig. 2 zeigt die im Schnitt in Fig. 1 dargestellte Anordnung in einer perspektivischen Darstellung.

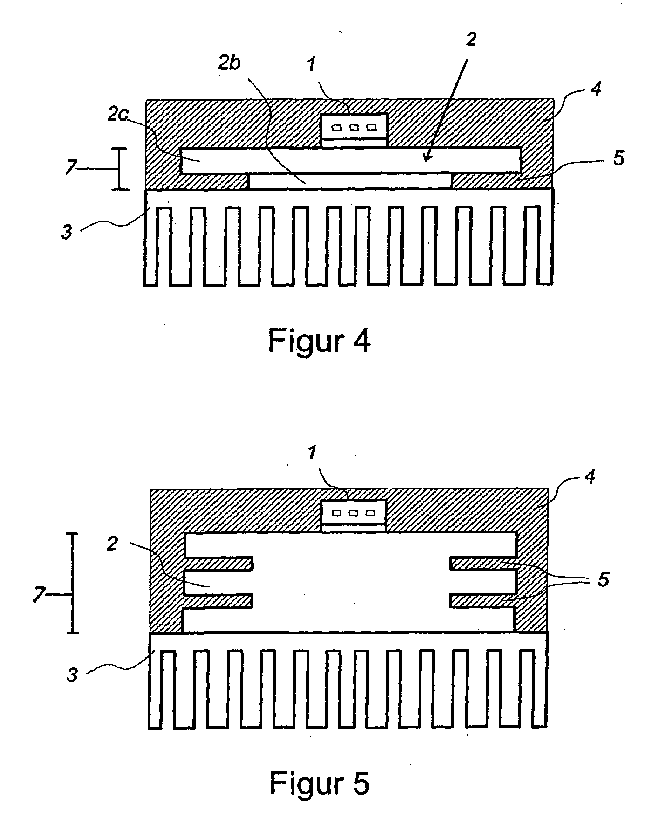

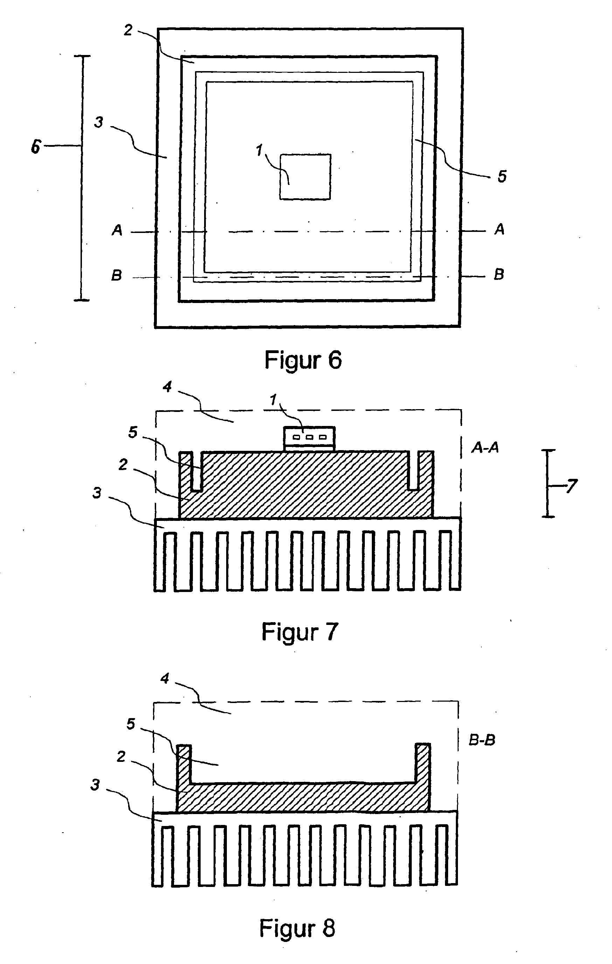

Während in dem Ausführungsbeispiel gemäß Fig. 1 die Schicht 2 bzw. der Trägerkörper aus miteinander verbundenen, vorzugsweise verklebten, Einzelteilen 2a, 2b, 2c aufgebaut ist, zeigt Fig. 3 im Schnitt ein ansonsten gleiches Ausführungsbeispiel, bei dem die Schicht 2 aber einstückig ausgebildet ist. Hier ist die nutförmige Ausnehmung 5 in die ursprünglich quaderförmige, die Schicht 2 bildende Platte eingeschnitten worden. Dasselbe gilt für das Ausführungsbeispiel gemäß Fig. 5. Das Ausführungsbeispiel gemäß Fig. 5 zeigt, dass grundsätzlich auch eine Abfolge von mehreren Nuten zum Erreichen der gewünschten Kriechwegverlängerung möglich sind. Genauso kann natürlich auch eine Abfolge von mehreren vorstehenden Elementen alleine oder in Kombination, mit Ausnehmungen verwendet werden. Die Fig. 6 bis 8 zeigen ein Ausführungsbeispiel, bei dem die Ausnehmung 5 nicht seitlich sondern auf der Seite, auf der auch das elektronische Bauteil 1 aufsitzt, grabenförmig in die Schicht 2 bzw. den Trägerkörper eingeschnitten ist. Fig. 6 zeigt eine Draufsicht, bei der die Haube aus isolierendem Medium 4 weggelassen ist. Fig. 7 zeigt einen Schnitt entlang der Geraden AA. Fig. 8 zeigt einen Schnitt entlang der Geraden BB.

Die erfindungsgemäßen Durchschlagfestigkeiten können am Material gemäß IEC 60672-2 bestimmt werden. Die spezifischen Wärmeleitfähigkeiten könnten gemäß der EN 821-3 bestimmt werden. Auch wenn bei den gezeigten erfindungsgemäßen Ausführungsbeispielen der Trägerkörper ausschließlich aus der Schicht 2 besteht, so kann dieser neben dieser Schicht 2 durchaus auch weitere Schichten aufweisen. Auch die Schicht 2 kann aus verschiedenen Materialien und auch geschichtet aufgebaut sein. Natürlich können auch mehrere, zum Beispiel mindestens drei, elektronische Bauteile auf einem Trägerkörper angebracht sein. Werden Trägerkörper bzw. Schicht 2 aus mehreren Einzelbauteilen zusammengesetzt, so ist ihre Verbindung besonders günstig mittels eines Klebers mit geeigneten Eigenschaften vorzunehmen.

## Patentansprüche

1. Anordnung mit zumindest einem elektronischen Bauteil und einem diesem zugeordneten Kühlkörper sowie einem räumlich zwischen dem elektronischen Bauteil und dem Kühlkörper angeordneten Trägerkörper, welcher zumindest eine Schicht mit zumindest einem Material mit einer Durchschlagfestigkeit von mindestens 10 kV/mm und einer spezifischen Wärmeleitfähigkeit von mindestens 5 W/mK aufweist, **dadurch gekennzeichnet, dass** in und/oder an der genannten Schicht (2) des Trägerkörpers zumindest eine vorzugsweise nut- oder grabenförmige Ausnehmung (5) und/oder zumindest ein vorzugsweise wandförmig ausgebildetes vorstehendes Element angeordnet ist, die und/oder das so ausgebildet ist, dass sie und/oder es entlang der Oberfläche der Schicht (2) des Trägerkörpers, vorzugsweise alle, elektrisch möglichen Wegsamkeiten zwischen dem elektronischen Bauteil (1) und dem Kühlkörper gegenüber dem Zustand der Schicht (2) des Trägerkörpers ohne die Ausnehmung (5) und/oder ohne das vorstehende Element verlängert(n).

2. Anordnung nach Anspruch 1, **dadurch gekennzeichnet, dass** die Ausnehmung (5) und/oder das vorstehende Element umlaufend bezüglich der Schicht (2) des Trägerkörpers und/oder des elektronischen Bauteils (1) und/oder des Kühlkörpers (3) ausgebildet ist.

3. Anordnung nach einem der Ansprüche 1 oder 2, **dadurch gekennzeichnet, dass** die Ausnehmung (5) und/oder das vorstehende Element so ausgebildet ist (sind), dass sie und/oder es die elektrisch möglichen Wegsamkeiten zwischen dem elektronischen Bauteil (1) und dem Kühlkörper (3) um mindestens 30 %, vorzugsweise mindestens 100 %, verlängert.

4. Anordnung nach einem der Ansprüche 1 bis 3, **dadurch gekennzeichnet, dass** die gesamte Schicht (2), vorzugsweise der gesamte Trägerkörper, und das gegebenenfalls vorhandene vorstehende Element aus ein und demselben Material gefertigt ist.

5. Anordnung nach einem der Ansprüche 1 bis 4, **dadurch gekennzeichnet, dass** die gesamte Schicht (2), vorzugsweise der gesamte Trägerkörper, und/oder das gegebenenfalls vorhandene vorstehende Element einstückig ausgebildet ist (sind).

6. Anordnung nach einem der Ansprüche 1 bis 4, **dadurch gekennzeichnet, dass** die gesamte Schicht (2), vorzugsweise der gesamte Trägerkörper, und das gegebenenfalls vorhandene vorstehende Element aus, vorzugsweise durch Verkleben, miteinander verbundenen Einzelteilen (2a, 2b, 2c) aufgebaut ist.

7. Anordnung nach einem der Ansprüche 1 bis 6, **dadurch gekennzeichnet, dass** das Material der Schicht (2) ein Aluminiumnitrid oder ein Aluminiumoxid aufweist oder ist.

8. Anordnung nach einem der Ansprüche 1 bis 7, **dadurch gekennzeichnet, dass** das elektronische Bauteil (1) ein Hochspannungsbauteil ist, welches für Betriebsspannungen zwischen 5 kV und 400 kV vorgesehen ist.

9. Anordnung nach einem der Ansprüche 1 bis 8, **dadurch gekennzeichnet, dass** die als Wärme abzuführende Verlustleistung des elektronischen Bauteils (1) zwischen 10 W und 10 kW liegt.

10. Anordnung nach einem der Ansprüche 1 bis 9, **dadurch gekennzeichnet, dass** das elektronische Bauteil (1) und/oder die Schicht (2), vorzugsweise der Trägerkörper, mit der Ausnehmung (5) und/oder dem vorstehenden Element in ein elektrisch isolierendes Medium (4), vorzugsweise in ein Isolieröl oder ein Isoliergas oder ein Gießharz, vorzugsweise vollständig, eingebettet ist.

11. Anordnung nach einem der Ansprüche 1 bis 10, **dadurch gekennzeichnet, dass** die Grundform der Schicht (2) und/oder des Trägerkörpers ohne die gegebenenfalls vorhandene Ausnehmung (5) und ohne das gegebenenfalls vorhandene vorstehende Element im Wesentlichen quaderförmig ist.

12. Anordnung nach einem der Ansprüche 1 bis 11, **dadurch gekennzeichnet, dass** die elektrische Kontaktierung und/oder die elektrischen Zu- oder Ableitungen zum elektronischen Bauteil (1) außerhalb der Schicht (2) und/oder des Trägerkörpers angeordnet sind.

13. Anordnung nach einem der Ansprüche 1 bis 12, **dadurch gekennzeichnet, dass** der Trägerkörper oder die Schicht (2) eine Mindestkantenlänge (6) von 100 mm und/oder eine Mindestdicke (7) von 2 mm aufweist.

14. Anordnung nach einem der Ansprüche 1 bis 5, **dadurch gekennzeichnet, dass** auf dem Trägerkörper oder der Schicht (2) mehrere, vorzugsweise mindestens drei, elektronische Bauteile (1) angeordnet sind.

## Claims

1. An arrangement comprising
• at least one electronic component (1),
• a cooling body (3) associated therewith,
• a support physically interposed between said electronic component (1) and said cooling body (3),
said support having at least one layer (2) with at least one material of a dielectric strength of at least 10 kV/mm and a specific thermal conductivity of at least 5 W/mK, wherein arranged in and/or at said layer (2) of said support is at least one recess (5) and/or at least one protruding element, said recess (5) and/or said protruding element being of such a configuration that said recess (5) and/or said protruding element extends or extend along the surface of said layer (2) of said support electrically possible pathways between said electronic component (1) and said cooling body as compared to the condition of said layer (2) of said support without said recess (5) and/or said protruding element.

2. The arrangement according to claim 1, wherein said recess (5) and/or said protruding element is or are of an encircling configuration with respect to at least one selected from the group consisting of said layer (2) of said support and said electronic component (1) and said cooling body (3).

3. The arrangement according to claim 1 or 2, wherein said recess (5) and/or said protruding element is or are of such a configuration that said recess (5) and/or said protruding element extend or extends the electrically possible pathways between said electronic component and said cooling body by at least 30%, preferably by at least 100%.

4. The arrangement according to one of the claims 1 to 4, wherein the whole layer (2), preferably the whole support, and/or said protruding element is or are made from one and the same material.

5. The arrangement according to one of the claims 1 to 3, wherein the whole layer (2), preferably the whole support, and/or said protruding element is or are of a one-piece configuration.

6. The arrangement according to one of the claims 1 to 4, wherein the whole layer (2), preferably the whole support, and/or said protruding element is or are constructed from, preferably by gluing, interconnected individual portions (2a, 2b, 2c).

7. The arrangement according to one of the claims 1 to 6, wherein the material of said layer of said support (2) is or comprises an aluminium nitride or an aluminium oxide.

8. The arrangement according to one of the claims 1 to 7, wherein said electronic component (1) is a high-voltage component provided for operating voltages of between 5 kV and 400 kV.

9. The arrangement according to one of the claims 1 to 8, wherein the power losses of said electronic component (1), which are to be dissipated in the form of heat, are between 10 W and 10 kW.

10. The arrangement according to one of the claims 1 to 9, wherein said electronic component (1) and/or said layer (2), preferably said support, with said recess (5) and/or said protruding element is or are, preferably completely, embedded in an electrically insulating medium, preferably in an insulting medium which is an insulating oil or an insulating gas or a casting resin.

11. The arrangement according to one of the claims 1 to 10, wherein the basic form of said support and/or said layer (2) without said recess (5) which is possibly present and without said protruding element which is possibly present, is substantially parallelepipedic.

12. The arrangement according to one of the claims 1 to 11, wherein electrical contacting means and/or electrical feed or discharge lines for said electronic component (1) is or are arranged outside said support and/or said layer (2).

13. The arrangement according to one of the claims 1 to 12, wherein said support or said layer (2) has a minimum edge length (6) of 100 mm and/or a minimum thickness of 2 mm.

14. The arrangement according to one of the claims 1 to 5, wherein a plurality, preferably at least three, of electronic components is arranged on said support or said layer (2).

## Revendications

1. Dispositif comprenant au moins un composant électronique et un corps de refroidissement affecté à celui-ci, ainsi qu'un corps de support disposé entre le composant électronique et le corps de refroidissement, lequel comporte au moins une couche avec au moins un matériau d'une rigidité diélectrique d'au moins 10 kV/mm et d'une conductivité thermique spécifique d'au moins 5 W/mK, **caractérisé en ce que** dans et/ou contre la couche (2) du corps de support susmentionnée sont disposés au moins un évidement (5) préférentiellement en forme de rainure ou de tranchée, et/ou au moins un élément en saillie préférentiellement réalisé en forme de paroi, ledit évidement et/ou élément étant réalisé de manière à prolonger sur la surface de la couche (2) du corps de support, préférentiellement toutes les perméabilités électriques possibles entre le composant électronique (1) et le corps de refroidissement par rapport à l'état de la couche (2) du corps de support sans l'évidement (5) et/ou sans l'élément en saillie.

2. Dispositif selon la revendication 1, **caractérisé en ce que** l'évidement (5) et/ou l'élément en saillie sont réalisés périphériquement par rapport à la couche (2) du corps de support et/ou du composant électronique (1) et/ou du corps de refroidissement (3).

3. Dispositif selon l'une des revendications 1 et 2, **caractérisé en ce que** l'évidement (5) et/ou l'élément en saillie sont réalisés de manière à prolonger d'au moins 300 %, préférentiellement d'au moins 100% les perméabilités électriques possibles entre le composant électronique (1) et le corps de refroidissement (3).

4. Dispositif selon l'une des revendications 1 à 3, **caractérisé en ce que** toute la couche (2), préférentiellement tout le corps de support, et l'élément en saillie éventuellement présent sont fabriqués en un seul et même matériau.

5. Dispositif selon l'une des revendications 1 à 4, **caractérisé en ce que** toute la couche (2), préférentiellement tout le corps de support, et/ou l'élément en saillie éventuellement présent sont réalisés d'un seul tenant.

6. Dispositif selon l'une des revendications 1 à 4, **caractérisé en ce que** toute la couche (2), préférentiellement tout le corps de support, et l'élément en saillie éventuellement présent sont constitués de pièces séparées (2a, 2b, 2c) assemblées entre elles préférentiellement par collage.

7. Dispositif selon l'une des revendications 1 à 6, **caractérisé en ce que** le matériau de la couche (2) comprend ou est un nitrure d'aluminium ou un oxyde d'aluminium.

8. Dispositif selon l'une des revendications 1 à 7, **caractérisé en ce que** le composant électronique (1) est un composant haute tension prévu pour des tensions comprises entre 5 kV et 400 kV.

9. Dispositif selon l'une des revendications 1 à 8, **caractérisé en ce que** la dissipation d'énergie du composant électronique (1) à dissiper en tant que chaleur est comprise entre 10 W et 10 kW.

10. Dispositif selon l'une des revendications 1 à 9, **caractérisé en ce que** le composant électronique (1) et/ou la couche (2), préférentiellement le corps de support, est noyé de préférence en totalité avec l'évidement (5) et/ou l'élément en saillie dans un milieu (4) électriquement isolant, préférentiellement dans une huile isolante, un gaz isolant ou une résine coulée.

11. Dispositif selon l'une des revendications 1 à 10, **caractérisé en ce que** la forme de base de la couche (2) et/ou du corps de support sans l'évidement (5) éventuellement présent et sans l'élément en saillie éventuellement présent est sensiblement parallélépipédique.

12. Dispositif selon l'une des revendications 1 à 11, **caractérisé en ce que** le contact électrique et/ou les conducteurs électriques d'arrivée vers le composant électrique (1) et de départ de celui-ci sont disposés à l'extérieur de la couche (2) et/ou du corps de support.

13. Dispositif selon l'une des revendications 1 à 12, **caractérisé en ce que** le corps de support ou la couche (2) présentent une longueur de bord minimale (6) de 100 mm et/ou une épaisseur minimale (7) de 2 mm.

14. Dispositif selon l'une des revendications 1 à 5, **caractérisé en ce que** plusieurs composants électroniques (1), de préférence au moins trois, sont disposés sur le corps de support ou sur la couche (2).
